# EUROPÄISCHE PATENTSCHRIFT

(11) **EP 0 927 460 B1**
(45) Veröffentlichungstag und Bekanntmachung des Hinweises auf die Patenterteilung: **08.11.2000**
(21) Anmeldenummer: 97941798.7
(22) Anmeldetag: 20.08.1997
(51) Int. Cl.: H03K 5/13

(54) **VERZÖGERUNGSSTUFE MIT STEILEN FLANKEN**
STEEP EDGE TIME-DELAY RELAY
MODULE DE RETARD A PENTES ABRUPTES

(30) Priorität: 18.09.1996 DE 19638163
(43) Veröffentlichungstag der Anmeldung: 07.07.1999
(73) Patentinhaber: SIEMENS AKTIENGESELLSCHAFT, 80333 München (DE)
(72) Erfinder: VON BASSE, Paul-Werner, D-82515 Wolfratshausen (DE); THEWES, Roland, D-82194 Gröbenzell (DE); BOLLU, Michael, D-81671 München (DE); SCHMITT-LANDSIEDEL, Doris, D-85521 Ottobrunn (DE)
(86) Internationale Anmeldenummer: DE9701802
(87) Internationale Veröffentlichungsnummer: WO9812812

(56) Entgegenhaltungen:
- EP-A- 0 330 405
- US-A- 5 180 938
- PATENT ABSTRACTS OF JAPAN vol. 007, no. 276 (E-215), 9.Dezember 1983 & JP 58 156226 A (HITACHI SEISAKUSHO KK), 17.September 1983,
- PATENT ABSTRACTS OF JAPAN vol. 095, no. 005, 30.Juni 1995 & JP 07 046098 A (NEC CORP), 14.Februar 1995, & US 5 598 111 A (ENOMOTO TOSHIO)

## Beschreibung

In Logikschaltungen werden zur Steuerung sequentieller Abläufe häufig verzögerte Flanken benötigt. Bei großen Verzögerungen tritt aber gleichzeitig auch eine Verlangsamung der Flanken bzw. eine Verringerung der Flankensteilheit auf oder die Verzögerung muß durch eine große Anzahl von einfachen Schaltungen, zum Beispiel durch Inverterketten, realisiert werden. Eine Maßnahme zur Beseitigung dieses Problems stellt beispielsweise eine Reihenschaltung aus einem RC-Glied bzw. einem Integrator und einem nachgeschalteten Schmitt-Trigger dar. Nachteilig ist hierbei, daß eine derartige Schaltung relativ aufwendig ist.

Aus der US-Patentschrift 5,180,938 ist eine Anordnung nach dem Oberbegriff von Anspruch 1 bekannt, bei der eine PMOS-Kapazität zwischen V0 und VCC und eine NMOS-Kapazität zwischen V0 und VSS vorgesehen ist und die an V0 wirksame Kapazität in einem mittleren Spannungsbereich für V0 kleiner ist als außerhalb dieses Bereiches. Dieser Effekt wird dazu genutzt, daß zum einen die Verzögerungszeit weitgehend unabhängig von der Versorgungsspannung wird und zum anderen die Bearbeitungsgeschwindigkeit bei niedrigen Versorgungsspannungen vergrößert wird.

Aus der japanischen Patentanmeldung JP-A-7-46098 bzw. aus den Patent Abstracts of Japan, Band 95, Nr. 5, 30. Juni 1995 ist eine Verzögerungsschaltung bekannt, bei der eine Kapazität zwischen dem Eingang und dem Ausgang der zweiten Inverterstufe vorhanden ist. Aus dem gesamten Dokument ist jedoch kein Hinweis in Richtung einer Realisierung der Kapazität durch eine Parallelschaltung einer PMOS-Kapazität mit einer NMOS-Kapazität zu finden. Die Schaltung ist jedoch relativ aufwendig, da ein Widerstand zwischen einer ersten und zweiten Inverterstufe und eine dritte Inverterstufe zur Impulsformung erforderlich sind.

Die der Erfindung zugrundeliegende Aufgabe liegt nun darin, eine Verzögerungsstufe mit steilen Flanken anzugeben, die einen möglichst geringen Schaltungsaufwand erfordert. Diese Aufgabe wird erfindungsgemäß durch die Merkmale des Patentanspruchs 1 gelöst. Eine vorteilhafte Ausgestaltung der Erfindung ergibt sich aus dem abhängigen Anspruch.

Die Erfindung wird anhand der Zeichnung näher erläutert. Dabei zeigt
- Figur 1: ein Schaltbild der erfindungsgemäßen Verzögerungsstufe,
- Figur 2: ein Spannungs/Spannungs-Diagramm zur Erläuterung der in Figur 1 dargestellten Schaltung und
- Figur 3: Spannungszeitdiagramme zur Erläuterung der in Figur 1 gezeigten Schaltung.

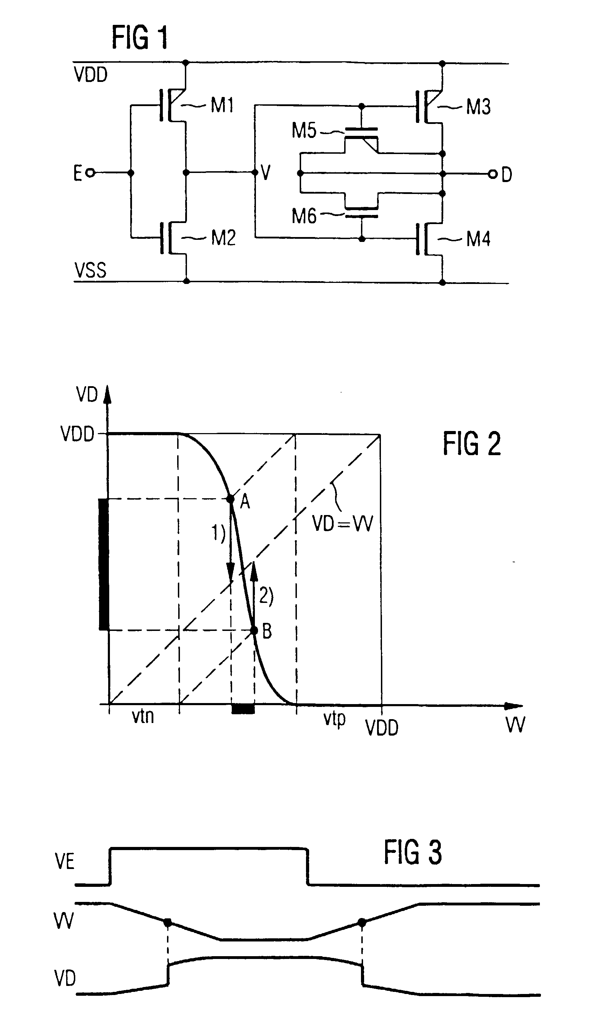

In Figur 1 ist eine Verzögerungsstufe mit zwei Invertern und zwei Kapazitäten dargestellt. Ein eingangsseitig mit einem Eingang E der Verzögerungsstufe verbundener erster Inverter weist einen p-Kanal-MOS-Transistor M1 und einen n-Kanal-Transistor M2 auf, die beide vorzugsweise sehr schmal und lang ausgebildet sind, damit sie im leitenden Zustand nur sehr kleine Ströme führen bzw. sehr hochohmig sind. Ein erster Anschluß des Transistors M1 ist mit einer Versorgungsspannung VDD und ein zweiter Anschluß des Transistors M1 mit einem Ausgang V des ersten Inverters verbunden. Entsprechend ist ein erster Anschluß des Transistors M2 mit dem Ausgang V und ein zweiter Anschluß des Transistors mit dem Bezugspotential VSS verbunden. Der zweite Inverter weist einen p-Kanal-MOS-Transistor M3 und einen n-Kanal-MOS-Transistor M4 auf, die beide im leitenden Zustand relativ niederohmig sind. Die Transistoren M1 und M2 sollten vorteilhafterweise im leitenden Zustand mindestens um den Faktor 10 hochohmiger sein als die Transistoren M1 und M2.

Die beiden Gates der Transistoren M3 und M4 sind mit dem Ausgang V der ersten Inverterstufe verbunden und bilden den Eingang der zweiten Inverterstufe. Ein erster Anschluß des Transistors M3 ist mit der Versorgungsspannung VDD und ein zweiter Anschluß des Transistors M3 mit dem Ausgang D der Verzögerungsstufe beschaltet. Entsprechend ist ein erster Eingang des Transistors M4 mit dem Ausgang D und ein zweiter Anschluß des Transistors M4 mit Bezugspotential VSS verbunden. Zwischen dem Ausgang D und dem Gate des Transistors M3 befindet sich eine erste Kapazität und zwischen dem Ausgang D und dem Gate des Transistors M4 befindet sich eine zweite Kapazität, wobei die erste Kapazität durch einen MOS-Transistor M5 gebildet wird, dessen Gate mit dem Gate des Transistors M3 und dessen Source und Drain mit dem Ausgang D verbunden sind und wobei die zweite Kapazität durch einen n-Kanal-MOS-Transistor M6 gebildet ist, dessen Gate mit dem Gate des Transistors M4 und dessen Source und Drain mit dem Anschluß D verbunden sind.

Die wesentliche Kapazität von diesen durch die Transistoren M5 und M6 gebildeten Kapazitäten wird durch die Kapazität zwischen Gate und Kanal gebildet, sobald die Spannung zwischen Gate- und Source-Anschluß größer als die Schwellspannung der Transistoren M5 bzw. M6 ist. Sobald die Spannung zwischen dem Ausgang V des ersten Inverters und dem Ausgang D des zweiten Inverters positiver ist als eine Schwelle Vtn, bildet der Transistor M6 einen Kanal und damit eine große Kapazität. Unterhalb dieser Schwelle ist der Kanal nicht vorhanden und es wirken nur kleine parasitäre Kapazitäten. Entsprechendes gilt für die zweite Kapazität, die durch den Transistor M5 gebildet wird. Hierbei bildet sich beim Transistor M5 erst dann ein Kanal, wenn die Spannung zwischen dem Ausgang V und dem Ausgang D negativer ist als eine Schwelle Vtp des Transistors M5. Im mittleren Bereich, bei dem die Differenzspannung zwischen der Spannung W am Ausgang V und der Spannung VD am Ausgang D kleiner oder gleich der Schwelle Vtn des n-Kanal-Transistors M6 und größer oder gleich der Schwelle Vtp des p-Kanal-Transistors M5 ist, wirken bei beiden durch die Transistoren M5 und M6 gebildeten Kapazitäten nur die vergleichsweise kleinen parasitären Kapazitäten.

Dieser mittlere Bereich wird als Kapazitätslücke bezeichnet und ist in Figur 2 an seinen Bereichsgrenzen durch die Buchstaben A und B gekennzeichnet. In Figur 2 ist auf der Ordinate VD und auf der Abszisse die Spannung W jeweils zwischen Null und VDD aufgetragen, wobei sich für kleine Werte von W für die Spannung VD ein Wert von ungefähr VDD und für große Werte von W ein Wert von ungefähr Null für die Spannung VD ergibt. In einem Spannungsbereich Vtn ≤ VV ≤ VDD - Vtp erfolgt ein s-förmiger Übergang, der den obengenannten Bereich zwischen A und B enthält.

Außerhalb der sogenannten Kapazitätslücke ist infolge der großen Kapazitäten die Verzögerung der erfindungsgemäßen Verzögerungsstufe vergleichsweise groß und damit die Flankensteilheit am Ausgang D vergleichsweise gering. Innerhalb der Kapazitätslücke hingegen ist die Verzögerung der Verzögerungsstufe klein und damit die Flankensteilheit am Ausgang D vergleichsweise groß. Der steile Verlauf liegt direkt im Umschaltbereich der Inverter, so daß nachfolgende Inverter mit steilen Flanken durchschalten. Die Verzögerung und die flachen Flanken liegen außerhalb des Umschaltbereiches der CMOS-Schaltkreise und stören somit nicht.

In Figur 3 ist eine rechteckförmige Eingangsspannung VE am Eingang E, die Spannung W am Ausgang V der ersten Inverstufe und die Spannung VD am Ausgang D der Verzögerungsstufe in zeitlicher Korrelation dargestellt. Hierbei wird deutlich, daß die Spannung VV relativ langsam nach der Anstiegsflanke der Spannung VE abfällt und relativ langsam nach der abfallenden Flanke der Spannung VE wieder ansteigt. In einem mittleren Bereich der langsam fallenden und langsam steigenden Bereiche der Spannung VV tritt am Ausgang D ein steiler Anstieg bzw. steiler Abfall der Spannung VD auf.

## Patentansprüche

1. Verzögerungsstufe,
bei der ein erster Inverter (M1,M2) und ein zweiter Inverter (M3,M4) in Reihe geschaltet sind, wobei der Eingang des ersten Inverters dem Eingang (E) der Verzögerungsstufe und der Ausgang des zweiten Inverters dem Ausgang (D) der Verzögerungsstufe entspricht, und der Ausgang des ersten Inverters mit dem Eingang (V) des zweiten Inverters verbunden ist, bei dem die zweite Inverterstufe einen p-Kanal-MOS-Transistor (M3) und einen n-Kanal-MOS-Transistor (M4) aufweisen, deren Drain-Anschlüsse mit dem Ausgang (D) der Verzögerungsschaltung verbunden sind, dadurch gekennzeichnet, daß
zwischen den mit dem Eingang (V) des zweiten Inverters verbundenen Gates des p-Kanal-MOS-Transistors und des n-Kanal-MOS-Transistors und dem Ausgang (D) der Verzögerungsschaltung eine Parallelschaltung mit Kapazitätslücke aus eines als Kapazität geschalteten p-Kanal-MOS-Transistors (M5) und eines als Kapazität geschalteten n-Kanal-MOS-Transistors (M6) vorgesehen ist.

2. Verzögerungsstufe,
bei der die MOS-Transistoren (M1, M2) des ersten Inverters im leitenden Zustand mindestens zehn mal hochohmiger sind als die MOS-Transistoren (M3, M4) des zweiten Inverters.

## Claims

1. Delay stage,
in which a first invertor (M1, M2) and a second invertor (M3, M4) are connected in series, the input of the first invertor corresponding to the input (E) of the delay stage and the output of the second invertor corresponding to the output (D) of the delay stage, and the output of the first invertor is connected to the input (V) of the second invertor,
in which the second invertor stage has a p-channel MOS transistor (M3) and an n-channel MOS transistor (M4), whose drain terminals are connected to the output (D) of the delay circuit, characterized in that
a parallel circuit with capacitance gap comprising a p-channel MOS transistor (M5) connected as a capacitor and an n-channel MOS transistor (M6) connected as a capacitor is provided between the gates of the p-channel MOS transistor and of the n-channel MOS transistor, the said gates being connected to the input (V) of the second invertor, and the output (D) of the delay circuit.

2. Delay stage,
in which the MOS transistors (M1, M2) of the first invertor have an impedance at least ten times higher, in the on state, than the MOS transistors (M3, M4) of the second invertor.

## Revendications

1. Module à retard,
dans lequel un premier inverseur (M1, M2) et un deuxième inverseur (M3, M4) sont montés en série, l'entrée du premier inverseur correspondant à l'entrée (E) du module de retard et la sortie du deuxième inverseur correspondant à la sortie (D) du module de retard, et la sortie du premier inverseur étant reliée à l'entrée (V) du deuxième inverseur,
dans lequel le deuxième étage inverseur comporte un transistor MOS (M3) à canal p et un transistor MOS (M4) à canal n, dont les bornes de drain sont reliées à la sortie (D) du circuit de temporisation,
**caractérisé par le fait**
que, entre les grilles du transistor MOS à canal p et du transistor MOS à canal n, reliées à l'entrée (V) du deuxième inverseur, et la sortie (D) du circuit de temporisation, est prévu un montage parallèle à trou de capacité comprenant un transistor MOS (M5) à canal p, connecté comme capacité, et un transistor MOS (M6) à canal n, connecté comme capacité.

2. Module à retard
dans lequel les transistors MOS (M1, M2) du premier inverseur ont, dans leur état passant, une impédance au moins dix fois supérieure à celle des transistors MOS (M3, M4) du second inverseur.
